# EUROPÄISCHE PATENTSCHRIFT

(11) **EP 0 484 586 B1**
(45) Veröffentlichungstag und Bekanntmachung des Hinweises auf die Patenterteilung: **25.01.1995**
(21) Anmeldenummer: 90121499.9
(22) Anmeldetag: 09.11.1990
(51) Int. Cl.: H01H 50/02

(54) **Elektromagnetisches Relais mit abgedichtetem Gehäuse**
Electromagnetic relay with sealed housing
Relais électromagnétique avec une boîte étanche

(43) Veröffentlichungstag der Anmeldung: 13.05.1992
(73) Patentinhaber: SIEMENS AKTIENGESELLSCHAFT, 80333 München (DE)
(72) Erfinder: Hendel, Horst, Dipl.-Ing. (FH), W-1000 Berlin 45 (DE)

(56) Entgegenhaltungen:
- EP-A- 0 262 622
- DE-A- 3 706 100
- FR-A- 2 529 428
- GB-A- 2 080 628
- US-A- 3 838 316

## Beschreibung

Die Erfindung betrifft ein elektromagnetisches Relais mit folgenden Merkmalen:
- ein Gehäuse besitzt eine Kappe und ein Bodenteil,
- in dem Gehäuse ist ein Spulenkörper mit einer zwischen zwei Flanschen aufgebrachten Wicklung angeordnet, deren Achse parallel zum Bodenteil verläuft,
- mindestens einer der Flansche mit in ihm verankerten Anschlußelementen steht in Richtung zur Unterseite des Relais über den Wicklungsumfang hinaus bis zu einer unteren Abschlußfläche des Gehäuses vor,
- im Bereich der unteren Abschlußfläche treten Anschlußelemente aus dem Relais aus und
- Durchbrüche im Bodenteil und eine Abdichtfuge zwischen dem Bodenteil und der Kappe sind mit Gießharz abgedichtet; siehe DE-U- 89 12 130.9.

Relais überdecken auf einer Leiterplatte gewöhnlich eine verhältnismäßig große Fläche, obwohl in der Regel die Anschlußstifte in verhältnismäßig kleinen Bereichen unterhalb der Flansche angeordnet sind. Der Raum zwischen den Flanschen, also unterhalb der Spulenwicklung (bei waagerechter Spulenachse), wird dagegen in den meisten Fällen nicht für eine Kontaktierung auf der Leiterplatte benutzt, so daß dieser Oberflächenbereich der Leiterplatte für die Beschaltung verloren geht. Zwar wäre schon aufgrund der zylinderförmigen Wicklung unterhalb und neben der Wicklung ein nicht ausgenutzter Raum vorhanden, doch wird dieser Raum bei der Einkapselung des Relais in ein quaderförmiges Gehäuse mit eingeschlossen, so daß er von außen nicht nutzbar ist. Das quaderförmige Gehäuse wird deshalb gewählt, weil sich auf diese Weise am einfachsten eine Abdichtung zwischen einer bis zur Leiterplattenoberfläche reichenden Kappe und einer entsprechenden Bodenplatte durchführen läßt. Bei der herkömmlichen Abdichtung wird Gießharz im Bereich der unteren Abschlußfläche auf das Bodenteil aufgebracht und in ein und derselben Ebene, beispielsweise durch Kapillarkanäle, zu allen Abdichtfugen und Durchbrüchen hin verteilt.

Zwar ist es aus der DE 37 06 100 A1 bekannt, in den Bodenteil eine von der unteren Abschlußfläche nach oben zur Wicklung hin eingebuchtete Kammer vorzusehen, in der gegebenenfalls auch unterhalb des Relais ein Bauelement angeordnet werden kann. Die Abdichtfuge zwischen Kappe und Bodenteil bleibt jedoch auch in diesem Fall umlaufend im Bereich der unteren Abschlußfläche, so daß die Kammer jedenfalls nach dem Aufsetzen des Relais auf die Leiterplatte nicht mehr zugänglich ist. Damit bleibt ein weiterer Nachteil des großflächigen quaderförmigen Gehäuses bestehen, nämlich die Tatsache, daß die gesamte Fläche unterhalb der Wicklung bei Löt- und Waschvorgängen nicht durchlüftet und gereinigt werden kann, so daß Rückstände von Lötmitteln und Waschmitteln gerade in diesem Bereich zurückbleiben. Ein in einer derartigen Kammer angeordnetes Bauelement könnte unter derartigen Rückständen leiden.

Aufgabe der Erfindung ist es, bei einem Relais der eingangs genannten Art mit abgedichtetem Gehäuse den toten Raum unterhalb und seitlich der Wicklung d.h. den durch die Zylinderform der Wicklung bedingten toten Raum seitlich von der unteren Scheitellinie und unterhalb der seitlichen Scheitellinie der Spule gebildeten Raum, also zwischen dem Wicklungszylinder und der unteren Abschlußebene des Relais, von außen zugänglich und nutzbar zu machen, zugleich aber ein geschlossenes Gehäuse vorzusehen, welches in einfacher Weise und in einem einzigen Arbeitsgang abgedichtet werden kann.

Erfindungsgemäß wird diese Aufgabe durch ein elektromagnetisches Relais mit den Merkmalen des Patentanspruches 1 gelöst.

Durch den erfindungsgemäß vorgesehenen Höhenversatz der Fügeebene zwischen Kappe und Bodenteil einschließlich der Abdichtfuge von der unteren Abschlußebene des Relais in einen Höhenbereich, der in der Gegend der unteren Scheitellinie der Wicklung liegt, kann unterhalb der Wicklung ein von außen zugänglicher freier Raum geschaffen werden, während diese höhenversetzte Abdichtfuge trotzdem mit bekannten Methoden in einem einzigen Arbeitsgang mit Gießharz versorgt werden kann.

Um den von der Wicklung nicht ausgefüllten Raum unter und neben der Spulenwicklung möglichst gut ausnutzen zu können, kann auch vorgesehen werden, daß der höhenversetzte Bodenabschnitt und die Fügeebene zur Kappe beiderseits der Wicklung höher liegen als deren unterer Scheitel, wobei in diesem Fall dann das Bodenteil den unteren Scheitelbereich der Wicklung mit einem an diese angepaßten Rundungsabschnitt umschließt. In einer zweckmäßigen Ausführungsform verläuft die Abdichtfuge zwischen der Kappe und dem Bodenteil umlaufend in Höhe des höhenversetzten Bodenabschnitts, wobei das Bodenteil mindestens einen nach unten bis zur unteren Abschlußebene vorstehenden Flansch des Spulenkörpers mit einer becherartigen Ausbuchtung umschließt. Diese becherartige Ausbuchtung kann dann beispielsweise in Höhe der unteren Abschlußebene mit Durchbrüchen für einzelne Anschlußstifte oder mit gemeinsamen Durchbrüchen für jeweils mehrere Anschlußstifte versehen sein.

Erfindungsgemäß weist das Bodenteil sowohl auf der jeweiligen Ausbuchtung in der unteren Abschlußebene als auch in dem höhenversetzten Bodenabschnitt Kapillarkanäle auf, welche jeweils eine Einfüllstelle für flüssiges Gießharz mit den Durchbrüchen im Bodenteil bzw. mit der Abdichtfuge in der Fügeebene verbinden. Besonders vorteilhaft ist es dabei, wenn eine gemeinsame Einfüllstelle vorgesehen ist, welche sowohl mit den Durchbrüchen im Bereich der unteren Abschlußfläche als auch mit der Abdichtfuge in der Fügeebene in Verbindung steht. Über Kapillarkanäle in den senkrecht oder schräg verlaufenden Verbindungswänden zwischen den unterschiedlichen Ebenen kann das Gießharz von der gemeinsamen Einfüllstelle zu beiden Ebenen hin verteilt werden. Die Einfüllstelle wird natürlich zweckmäßigerweise in der unteren Abschlußebene vorgesehen, da das Gießharz bei umgedrehtem Relais leichter von der höheren Ebene zu der tieferen hin verläuft. Generell sei noch erwähnt, daß die Form und Dimensionierung der Einfüllstellen und der Verteilungskanäle in herkömmlicher Weise gewählt werden können, wie sie beispielsweise in der DE 30 26 371 A1, der EP 0 262 622 A1 oder in dem DE 90 11 111 U beschrieben sind; beispielsweise können anstelle von Kanälen auch Rippen vorgesehen sein.

In der jeweiligen becherförmigen Ausbuchtung des Bodenteils können im Bereich der unteren Abschlußebene des Relais ein oder mehrere Durchbrüche vorgesehen sein, durch welche nicht einzelne Anschlußstifte, sondern von Flanschansätzen des Spulenkörpers einzeln oder gemeinsam ummantelte Anschlußelemente nach außen geführt sind. In diesem Fall erfolgt eine Abdichtung zwischen den Flanschansätzen und dem Bodenteil, gegebenenfalls auch zusätzlich zwischen den Anschlußstiften und den Flanschansätzen des Spulenkörpers. Die zusätzliche Abdichtung der Anschlußstifte selbst ist dann nicht erforderlich, wenn diese im Spulenkörper bereits dicht eingebettet sind. Es ist aber auch möglich, daß sich der höhenversetzte Bodenabschnitt zumindest über einen der Flansche hinweg ohne die erwähnte becherförmige Ausbuchtung bis zum Rand der Kappe erstreckt. In diesem Bodenabschnitt werden dann Durchbrüche für Anschlußstifte vorgesehen, wobei diese Anschlußstifte zweckmäßigerweise von säulenförmigen, sich bis zur unteren Abschlußebene des Relais erstreckenden Spulenkörperansätzen ummantelt sind und wobei die Abdichtung mit Gießharz zwischen dem Bodenteil und den Spulenkörperansätzen in der höhenversetzten Fügeebene erfolgt.

In weiterer Abwandlung ist es auch möglich, daß sich das Bodenteil im wesentlichen lediglich im Bereich des höhenversetzten Bodenabschnitts - gegebenenfalls mit einem an die Wicklung angepaßten Rundungsabschnitt - erstreckt und daß sich Flanschansätze und/oder säulenförmige Spulenkörperansätze mit eingebetteten Anschlußstiften zwischen Kappenrand und Bodenteil und/oder in Druchbrüchen des Bodenteils bis zur unteren Abschlußebene erstrecken. Wenn in diesem Fall die Anschlußelemente bereits dicht in die Flanschansätze bzw. in die säulenförmigen Spulenkörperansätze eingebettet sind, braucht die Gehäuseabdichtung mit Gießharz lediglich im Bereich der höhenversetzten Fügeebene vorgenommen zu werden.

Die Erfindung wird nachfolgend an Ausführungsbeispielen anhand der Zeichnung näher erläutert. Es zeigt
Figur 1 ein erfindungsgemäß gestaltetes Relais mit einem zwei Spulenflansche umschließenden Bodenteil,
Figur 2 eine gegenüber Figur 1 abgewandelte Ausführungsform, bei dem nur ein Flansch vom Bodenteil ummantelt wird,
Figur 3 eine Explosionsdarstellung der Gehäuseelementekappe, des Spulenkörpers und des Bodenteils des Relais von Figur 2,
Figuren 4 und 5 weitere Abwandlungen gegenüber Figur 2.

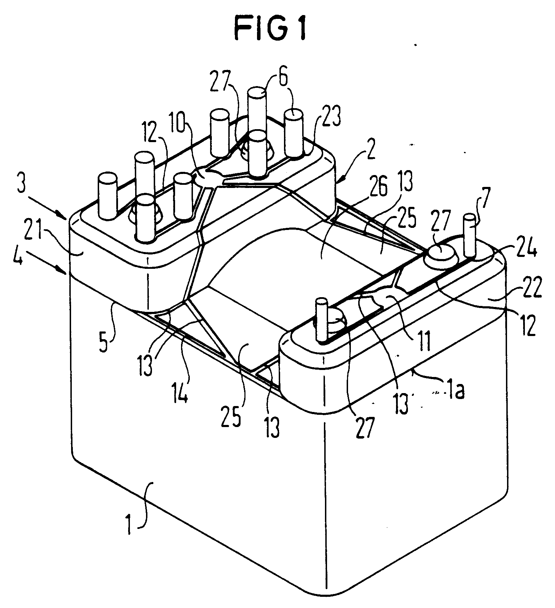

Das in Figur 1 in perspektivischer Darstellung mit der Anschlußseite nach oben gezeigte Relais besitzt ein Gehäuse, welches aus einer Kappe 1 und einem Bodenteil 2 gebildet ist. Der Spulenkörper mit waagerechter Wicklungsachse ist in diesem Fall vollständig in dem Gehäuse eingeschlossen. Die Kappe erstreckt sich jedoch mit ihrem unteren (auf die normale Einbaulage bezogen) Rand 1a nicht bis zur unteren Abschlußebene 3 des Relais, sondern lediglich bis zu einer höhenversetzten Fügeebene 4, wo eine umlaufende Trennfuge 5 zwischen der Kappe 1 und dem Bodenteil 2 verläuft und abzudichten ist.

Das Bodenteil 2 besitzt zwei becherförmige Ausbuchtungen 21 und 22, die jeweils einen Flansch des Spulenkörpers umschließen und in Höhe der unteren Abschlußebene 3 jeweils Durchbrüche 23 bzw. 24 für Kontaktanschlußelemente 6 bzw. Spulenanschlußelemente 7 aufweisen. Im Bereich zwischen den Ausbuchtungen 21 und 22 besitzt das Bodenteil beiderseits der Spulenwicklung sich erstreckende flache Abschnitte 25 in der höhenversetzten Fügeebene 4, zwischen denen ein Rundungsabschnitt 26 in Form einer Zylindermantelfläche sich eng an den unteren Scheitelbereich der Spulenwicklung anschließt. Auf den Ausbuchtungen 21 und 22 sind außerdem im Bereich der unteren Abschlußebene 3 Abstandsnasen 27 angeformt. Diese gewährleisten in bekannter Weise auch im Bereich der Anschlußstifte 6 bzw. 7 einen geringen Freiraum zwischen der unteren Abschlußfläche 3 des Relais und einer Leiterplatte, wodurch Lötdämpfe und dergleichen abgeführt werden können.

Im übrigen ermöglicht der große Freiraum unterhalb der Spule zwischen der unteren Abschlußebene 3 und der Fügeebene 4 nicht nur die Anordnung von zusätzlichen Bauelementen unter dem Relais, sondern er erleichtert auch das Waschen der Leiterplatte nach dem Lötvorgang, da nur die Mindestflächen im Bereich der Anschlußstifte bzw. der Flansche die Leiterplatte relativ eng abdecken. Der Bereich unter der Spule ist auch bei dem geschlossenen Gehäuse des Relais frei zugänglich.

Die Abdichtung erfolgt mit Gießharz, welches über ein Kapillarsystem an alle abzudichtenden Stellen geführt wird. Bei dem Beispiel von Figur 1 sind zwei Einfüllstellen 10 und 11, jeweils eine auf den beiden Ausbuchtungen 21 und 22 des Bodenteils 2, vorgesehen. Von diesen Einfüll- oder Dosierstellen 10 bzw. 11 führen Kapillarkanäle 12 zu den einzelnen Anschlußstiften 6 bzw. 7. Weitere Kapillarkanäle 13 führen von den Einfüllstellen 10 und 11 über eine oder mehrere Seitenwände der Ausbuchtungen 21 bzw. 22 zu dem höhenversetzten Bodenabschnitt 25, zu einem Randkanal 14 und zu allen abzudichtenden Trennfugen 5 zwischen der Kappe 1 und dem Bodenteil 2. Bei dem Beispiel würde es auch genügen, wenn lediglich von einer Einfüllstelle 10 die Versorgung der Abdichtstellen in dem höhenversetzten Bereich der Fügeebene 4 versorgt würden. Die Form der Einfüllstellen und die Form und Dimensionierung der Kapillarleitungen ist hier nur schematisch angedeutet. Es kommen natürlich die dem Fachmann geläufigen Formen von Kanälen oder Rippen, wie oben bereits erwähnt, in Betracht. Die Dimensionierung richtet sich nach den abzudichtenden Stellen, der Entfernung zu diesen und nach den Eigenschaften des Gießharzes.

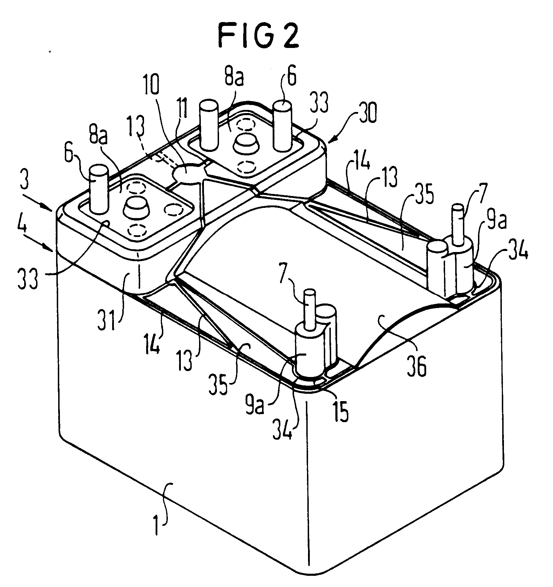

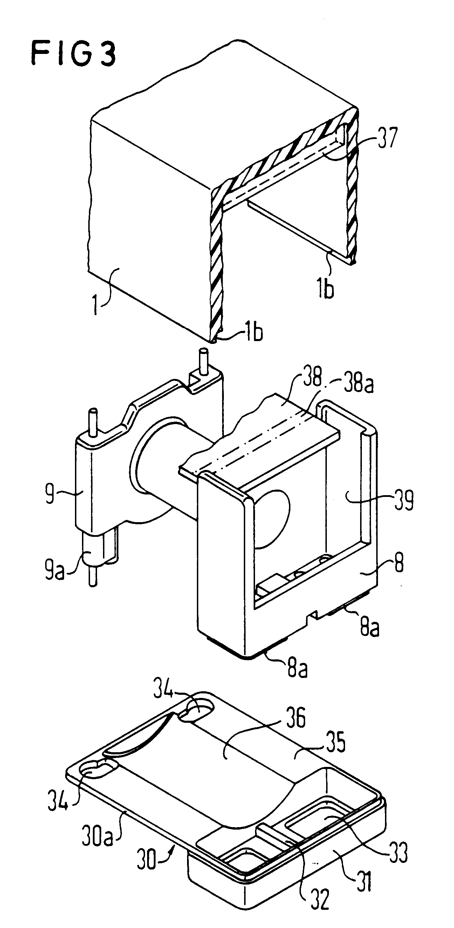

In Figur 2 ist eine Abwandlung des Relaisgehäuses von Figur 1 zu sehen, wobei die gesamte Abdichtung von einer einzigen Einfüllstelle 10 aus möglich ist. In diesem Fall besitzt ein Bodenteil 30 lediglich eine becherförmige Ausbuchtung 31, die einen Flansch 8 (siehe Figur 3) umschließt. Im übrigen erstreckt sich ein höhenversetzter Bodenabschnitt 35 mit einem Rundungsabschnitt 36 in Höhe der Fügeebene 4 bis zum entgegengesetzten Ende des Relais, also auch über den zweiten Flansch 9 hinweg. Dieser zweite Flansch 9 (Figur 3) besitzt lediglich säulenförmige Ansätze 9a, welche in Durchbrüchen 34 in Höhe der Fügeebene 4 durch das Bodenteil gesteckt sind. Da die Spulenanschlußstifte 7 in diesen säulenförmigen Ansätzen 9a bereits dicht eingebettet sind, genügt eine Abdichtung über die Kanäle 15, welche wie die übrigen Fugen und Randkanäle 14 von der gemeinsamen Einfüllstelle 10 mit Gießharz versorgt werden.

Die becherförmige Ausbuchtung 31 besitzt im Beispiel von Figur 2 keine getrennt abzudichtenden Durchbrüche für die einzelnen Anschlußstifte 6, sondern zwei größere Durchbrüche 33, in die jeweils Flanschansätze 8a des Spulenkörperflansches 8 hineinragen. Durch Einleitung von Gießharz in die Durchbrüche 33 wird der Rand zwischen den Flanschansätzen 8a und dem Bodenteil abgedichtet, gegebenenfalls auch Durchbrüche für die Anschlußstifte 6 in den Flanschansätzen 8a, falls die Stifte noch nicht dicht eingebettet sind. Somit kann sowohl eine Befestigung der Anschlußstifte 6 durch Einstecken und nachträgliches Abdichten oder eine Einbettung durch Spritzgießen oder dergleichen angewendet werden.

Figur 3 zeigt in perspektivischer Darstellung die Teile des Relais, welche zusammen das Gehäuse bilden bzw. an der Abdichtung nach außen beteiligt sind. Zu sehen ist das Bodenteil 30 mit der becherförmigen Ausbuchtung 31, in der die Durchbrüche 33 ausgespart sind. Eine Rippe 32 zwischen den Durchbrüchen dient zur mechanischen Stabilisierung. Denkbar wäre aber auch, daß in der Ausbuchtung 31 ein einziger großer Durchbruch 33 für einen entsprechend großen Flanschansatz 8a vorgesehen wäre. Am anderen Ende des Bodenteils 30 sind lediglich in dem höhenversetzten Bodenabschnitt 35 die zwei kleineren Durchbrüche 34 für die säulenförmigen Ansätze 9a des Spulenflansches 9 ausgespart. Die geschnitten gezeichnete Kappe 1 besitzt einen umlaufenden Falz 1b, mit dem sie um den Rand 30a des Bodenteils greift und mit diesem eine ringsum abdichtbare Fuge bildet.

Wie in Figur 3 gezeigt, ist an der Innenseite der Kappe eine Innenrippe 37 angeformt, welche nach dem Zusammenbau auf dem nur andeutungsweise gezeichneten Joch 38 auf der angedeuteten Berührungsfläche 38a aufliegt. Zusammen mit dem Flansch 8 bildet die Innenrippe 37 somit eine Trennwand zwischen dem Kontaktraum 39 und der Spulenwicklung, so daß kontaktschädliche Partikel aus dem Spulenwickelraum nicht zu den Kontakten gelangen können. Dabei wäre es auch denkbar, die Fugen im Bereich der Innenrippe 37 zusätzlich mit Gießharz abzudichten oder auch den Spulenraum vollständig mit einer Dichtungsmasse auszufüllen. Diese Dichtungsmasse könnte dann eine verbesserte Wärmeableitung von der Spule nach außen gewährleisten.

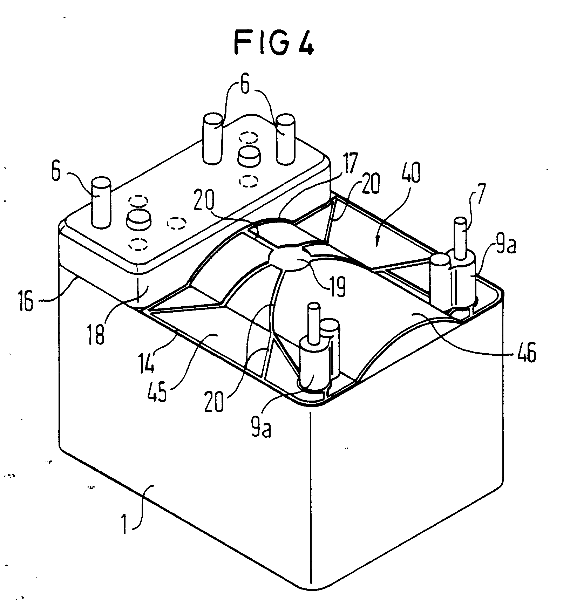

In Figur 4 ist eine weitere Abwandlung des Relais gezeigt. In diesem Fall bildet ein Bodenteil 40 lediglich den höhenversetzten Bodenabschnitt 45 mit dem Rundungsabschnitt 46, während ein Spulenkörperansatz 18 den gesamten bis zur unteren Abschlußebene reichenden Gehäuseteil bildet. Die Anschlußstifte 6 können in diesem Fall in den Spulenkörperansatz 18 eingebettet sein. Am entgegengesetzten Ende sind wie im vorhergehenden Beispiel von Figur 2 säulenförmige Spulenkörperansätze 9a als Fortsätze des Spulenflansches 9 vorgesehen und durch das Bodenteil geführt. Die Abdichtung erfolgt also in diesem Fall zwischen der Kappe 1 und dem Flanschansatz 18 in der Abdichtfuge 16, zwischen der Kappe 1 und dem Bodenteil 40 im Bereich des Randkanals 14 sowie zwischen dem Bodenteil 40 und dem Flanschansatz 18 an dem Randkanal 17. Die säulenförmigen Spulenkörperansätze 9a werden wie in dem Beispiel von Figur 2 abgedichtet. Die Versorgung mit Gießharz erfolgt in diesem Fall von einer zentralen Einfüllstelle 19 über Kapillarkanäle 20 auf dem Bodenteil.

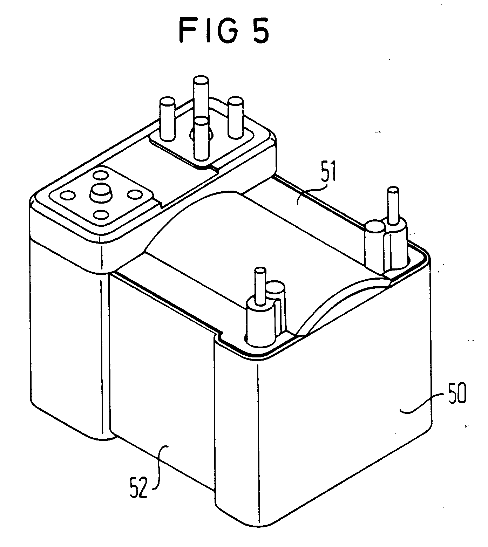

Figur 5 zeigt eine weitere Abwandlung des Gehäuses von Figur 2. Hier wird das Gehäuse von einer Kappe 50 in Verbindung mit einem Bodenteil 51 gebildet. Dabei ist nicht nur in der bereits beschriebenen Weise ein Freiraum unterhalb der Spule durch entsprechende Gestaltung des Bodenteils 51 geschaffen, sondern die Kappe 50 ist auch seitlich von der Spulenwicklung mit Einschnürungen 52 versehen. Dadurch wird zusätzliches, im Inneren der Spule nicht benötigtes bzw. nicht nutzbares Volumen nach außen verlegt und dadurch frei zugänglich. Das Gehäusevolumen wird damit insgesamt verkleinert, was beispielsweise auch das Luftvolumen im Relais verringert. Dieses Luftvolumen sollte so klein wie möglich gehalten werden, da es sich bei Temperaturschwankungen in unerwünschter Weise vergrößert und insgesamt die Wärmeableitung beeinträchtigt. Im übrigen sind Gestaltung und Abdichtverfahren bei dem Relais gemäß Figur 5 so wie anhand von Figur 2 bereits beschrieben.

## Patentansprüche

1. Elektromagnetisches Relais mit folgenden Merkmalen:
- ein Gehäuse besitzt eine Kappe (1) und ein Bodenteil (2; 30; 40),
- in dem Gehäuse ist ein Spulenkörper mit einer zwischen zwei Flanschen (8, 9) aufgebrachten Wicklung angeordnet, deren Achse parallel zum Bodenteil verläuft,
- mindestens einer der Flansche (8, 9) mit in ihm verankerten Anschlußelementen (6, 7) steht in Richtung zur Unterseite des Relais über den Wicklungsumfang hinaus bis zu einer unteren Abschlußebene (3) des Gehäuses vor,
- im Bereich der unteren Abschlußebene (3) treten Anschlußelemente (6, 7) aus dem Relais aus und
- Durchbrüche (23, 24; 33, 34) im Bodenteil und eine Abdichtfuge (5; 14) zwischen dem Bodenteil und der Kappe sind mit Gießharz abgedichtet,
**dadurch gekennzeichnet,** daß das Bodenteil (2; 30; 40) einen Bodenabschnitt (25; 35; 45) aufweist, der im Bereich unterhalb der Wicklung sich annähernd an deren untere Scheitellinie anschmiegt und sich seitlich davon bis zu der zwischen dem Bodenteil (2; 30; 40) und der Kappe (1) gebildeten Abdichtfuge (5; 14, 16, 17) erstreckt, daß sich die Abdichtfuge (5; 14, 16, 17) in einer Fügeebene (4) erstreckt, die zumindest in Höhe der unteren Scheitellinie der Wicklung liegt, und daß in dem Bodenteil (2; 30; 40) mindestens eine Einfüllstelle (10, 11) für Gießharz sowie ein kapillares Verteilungsnetz (13) zur Förderung von Gießharz zu den Durchbrüchen (23, 24; 33, 34) im Bodenteil (2; 30; 40) und zu der Abdichtfuge (5; 14, 16, 17) vorgesehen sind.

2. Relais nach Anspruch 1, **dadurch gekennzeichnet,** daß der höhenversetzte Bodenabschnitt (25; 35; 45) und die Fügeebene (4) zur Kappe beiderseits der unteren Scheitellinie der Wicklung höher liegen als diese und daß das Bodenteil (2; 30; 40) den unteren Scheitelbereich der Wicklung mit einem an diesen angepaßten Rundungsabschnitt (26; 36; 46) umschließt.

3. Relais nach Anspruch 1 oder 2, **dadurch gekennzeichnet,** daß die Abdichtfuge (5) zwischen der Kappe (1) und dem Bodenteil (2; 30) umlaufend in Höhe des höhenversetzten Bodenabschnitts (25; 35) verläuft und daß das Bodenteil (2; 30) mindestens einen nach unten bis zur unteren Abschlußebene (3) vorstehenden Flansch mit einer becherförmigen Ausbuchtung (21, 22; 31) umschließt.

4. Relais nach Anspruch 3, **dadurch gekennzeichnet,** daß mindestens eine becherförmige Ausbuchtung (21, 22; 31) mit Durchbrüchen für Anschlußstifte (6, 7) versehen ist.

5. Relais nach Anspruch 3 oder 4, **dadurch gekennzeichnet,** daß das Bodenteil (2; 30) sowohl auf der jeweiligen Ausbuchtung (21, 22; 31) in der unteren Abschlußebene als auch in dem höhenversetzten Bodenabschnitt (25; 35) Kapillarstrecken aufweist, welche jeweils eine Einfüllstelle (10, 11) für flüssiges Gießharz mit den Durchbrüchen (23, 24; 33, 34) bzw. der Abdichtfuge (5) in der Fügeebene verbinden.

6. Relais nach Anspruch 5, **dadurch gekennzeichnet,** daß eine gemeinsame Einfüllstelle (10) sowohl mit den Durchbrüchen (33) im Bereich der unteren Abschlußebene (3) als auch mit der Abdichtfuge (5) in der Fügeebene (4) in Verbindung steht.

7. Relais nach einem der Ansprüche 3 bis 6, **dadurch gekennzeichnet,** daß eine becherförmige Ausbuchtung (31) im Bereich der unteren Abschlußebene (3) einen oder mehrere Durchbrüche (33) aufweist, in welchen von Flanschansätzen (8a) des Spulenkörpers einzeln oder gemeinsam ummantelte Anschlußstifte (6) nach außen geführt sind, wobei eine Abdichtung zwischen den Flanschansätzen und dem Bodenteil (30) und gegebenenfalls zusätzlich zwischen den Anschlußstiften (6) und den Flanschansätzen (8a) erfolgt,

8. Relais nach einem der Ansprüche 1 bis 7, **dadurch gekenn-** **zeichnet,** daß sich der höhenversetzte Bodenabschnitt (35; 45) zumindest über einen Flansch hinweg bis zum Rand der Kappe (1) erstreckt und daß in diesem Bodenabschnitt (35; 45) Durchbrüche (34) für Anschlußstifte (7) vorgesehen sind, wobei die Anschlußstifte von säulenförmigen, sich bis zur unteren Abschlußebene (3) erstreckenden Spulenkörperansätzen (9a) ummantelt sind und wobei die Abdichtung mit Gießharz zwischen dem Bodenteil (30; 40) und den Spulenkörperansätzen (9a) in der höhenversetzten Fügeebene (4) erfolgt.

9. Relais nach Anspruch 1 oder 2, **dadurch gekennzeichnet,** daß sich das Bodenteil (40) im wesentlihen lediglich im Bereich des höhenversetzten Bodenabschnitts (45) erstreckt und daß sich Flanschansätze (18) und/oder säulenförmige Spulenkörperansätze (9a) mit eingebetteten Anschlußstiften (6; 7) zwischen Kappenrand und Bodenteil (40) und/oder in Durchbrüchen (34) des Bodenteils bis zur unteren Abschlußebene erstrecken.

10. Relais nach einem der Ansprüche 1 bis 9, **dadurch gekenn****zeichnet,** daß die Kappe (50) im Bereich seitlich neben der Spulenwicklung mit zusätzlichen Einschnürungen (52) versehen ist.

## Claims

1. Electromagnetic relay having the following features:
- a housing has a cap (1) and a base part (2; 30; 40),
- in the housing a coil former is arranged with a winding which is applied between two flanges (8, 9), the axis of the winding running parallel to the base part,
- at least one of the flanges (8, 9) with connecting elements (6, 7) anchored therein projects in the direction of the underside of the relay beyond the circumference of the winding up to a lower terminating plane (3) of the housing,
- in the region of the lower terminating plane (3) connecting elements (6, 7) emerge from the relay, and
- perforations (23, 24; 33, 34) in the base part and a sealing joint (5; 14) between the base part and the cap are sealed with casting resin,
characterized in that the base part (2; 30; 40) has a base section (25; 35; 45) which in the region below the winding nestles approximatly against the lower apex line of the winding and laterally thereof extends to the sealing joint (5; 14, 16, 17) formed between the base part (2; 30; 40) and the cap (1), in that the sealing joint (5; 14, 16, 17) extends in a joining plane (4) which is located at least at the level of the lower apex line of the winding, and in that in the base part (2; 30; 40) at least one filling point (10, 11) for casting resin and a capillary distribution network (13) for conveying casting resin to the perforations (23, 24; 33, 34) in the base part (2; 30; 40) and to the sealing joint (5; 14, 16, 17) are provided.

2. Relay according to Claim 1, characterized in that the base section (25; 35; 45), offset in height, and the joining plane (4) to the cap on both sides of the lower apex line of the winding are located higher than said apex line and in that the base part (2; 30; 40) surrounds the lower apex region of the winding with a rounded section (26; 36; 46) matched thereto.

3. Relay according to Claim 1 or 2, characterized in that the sealing joint (5) runs circumferentially between the cap (1) and the base part (2; 30) at the level of the base section (25; 35), offset in height, and in that the base part (2; 30) surrounds at least one flange which projects downwards to the lower terminating plane (3) and has a cup-shaped bulge (21, 22; 31).

4. Relay according to Claim 3, characterized in that at least one cup-shaped bulge (21, 22; 31) is provided with perforations for connecting pins (6, 7).

5. Relay according to Claim 3 or 4, characterized in that the base part (2; 30) has capillary paths both on the respective bulge (21, 22; 31) in the lower terminating plane and in the base section (25; 35), offset in height, which capillary paths in each case connect one filling point (10, 11) for liquid casting resin to the perforations (23, 24; 33, 34) or the sealing joint (5) in the joining plane.

6. Relay according to Claim 5, characterized in that a common filling point (10) is connected both to the perforations (33) in the region of the lower terminating plane (3) and to the sealing joint (5) in the joining plane (4).

7. Relay according to one of Claims 3 to 6, characterized in that a cup-shaped bulge (31) has in the region of the lower terminating plane (3) one or more perforations (33) in which connecting pins (6), which are sheathed individually or jointly by flange attachments (8a) of the coil former, are passed outwards, a sealing being carried out between the flange attachments and the base part (30) and, in addition, possibly between the connecting pins (6) and the flange attachments (8a).

8. Relay according to one of Claims 1 to 7, characterized in that the base section (35; 45), offset in height, extends beyond at least one flange to the edge of the cap (1) and in that perforations (34) for connecting pins (7) are provided in this base section (35; 45), the connecting pins being sheathed by column-shaped coil former attachments (9a), extending to the lower terminating plane (3), and the sealing with casting resin between the base part (30; 40) and the coil former attachments (9a) being carried out in the joining plane (4), offset in height.

9. Relay according to Claim 1 or 2, characterized in that the base part (40) essentially extends only in the region of the base section (45), offset in height, and in that flange attachments (18) and/or column-shaped coil former attachments (9a) having embedded connecting pins (6; 7) extend between the cap edge and the base part (40) and/or in perforations (34) of the base part to the lower terminating plane.

10. Relay according to one of Claims 1 to 9, characterized in that the cap (50) is provided in the region laterally beside the coil winding with additional constrictions (52).

## Revendications

1. Relais électromagnétique présentant les caractéristiques suivantes:
- un boîtier possède un capot (1) et une partie de fond (2;30;40),
- dans le boîtier est disposé un corps de bobine comportant un enroulement disposé entre deux brides (8,9) et dont l'axe est parallèle à la partie de fond,
- au moins l'une des brides (8,9) pourvue d'éléments de raccordement (6,7) qui sont ancrés dans celle-ci, fait saillie en direction de la face inférieure du relais, au-delà du pourtour de l'enroulement, jusqu'à un plan inférieur de terminaison (3),
- des éléments de raccordement (6,7) ressortent du relais, dans la zone du plan inférieur de terminaison (3), et
- des passages (23,24; 33,24) ménagés dans la partie de fond et un joint d'étanchéité (5;14) situé entre la partie de fond et le capot sont fermés de façon étanche par une résine de coulée,
caractérisé par le fait que la partie de fond (2;30,40) possède une section de fond (25;35;45), qui épouse approximativement la forme de la ligne sommitale inférieure de l'enroulement, dans la zone située sous l'enroulement et s'étend latéralement par rapport à cette ligne jusqu'au joint d'étanchéité (5;14,16,17), qui est formé entre la partie de fond (2;30;40) et le capot (1), le joint d'étanchéité (5;14,16,17) s'étend dans un plan de jonction (4), qui est situé au moins à hauteur de la ligne sommitale inférieure de l'enroulement, et dans la partie de fond (2;30;40) sont disposés au moins un point de remplissage (10,11) pour la résine de coulée ainsi qu'un réseau de distribution capillaire (13) servant à entraîner la résine de coulée en direction des passages (23,24;33,34) dans la partie de fond (2;30;40) et en direction du joint d'étanchéité (5; 14,16,17).

2. Relais suivant la revendication 1, caractérisé par le fait que la section de fond (25;35;45) décalée en hauteur et le plan (4) de jonction avec le capot sont, des deux côtés de la ligne sommitale inférieure de l'enroulement, à un niveau plus élevé que cette ligne et la partie de fond (2;30;40) entoure la zone sommitale inférieure de l'enroulement par une section arrondie (26;36;46) adaptée à cette partie sommitale.

3. Relais suivant la revendication 1 ou 2, caractérisé par le fait que le joint d'étanchéité (5) s'étend, entre le capot (1) et la partie de fond (2;30), selon un contour fermé à hauteur de la section de fond (25;35) décalée en hauteur, et la partie de fond (2;30) entoure au moins une bride, qui fait saillie vers le bas jusqu'au plan inférieur de terminaison (3), par une pièce en forme de pot (21,22; 31).

4. Relais suivant la revendication 3, caractérisé par le fait qu'au moins une pièce en forme de pot (21,22;31) est pourvue de passages pour des broches de raccordement (6,7).

5. Relais suivant la revendication 3 ou 4, caractérisé par le fait que la partie de fond (2;3) possède, dans le plan inférieur de fermeture ainsi que dans la section de fond (25;35) décalée en hauteur, des sections capillaires, qui relient respectivement un point de remplissage (10,11) pour une résine de coulée liquide aux passages (23,24;33,34) ou au joint d'étanchéité (5) dans le plan de jonction.

6. Relais suivant la revendication 5, caractérisé par le fait qu'un point de remplissage commun (10) est relié aussi bien aux passages (33) au voisinage du plan inférieur de terminaison (3) qu'au joint d'étanchéité (5) dans le plan de jonction (4).

7. Relais suivant l'une des revendications 3 à 6, caractérisé par le fait qu'une partie conformée en forme de pot (31) possède, au niveau du plan inférieur de terminaison (3), un ou plusieurs passages (33), dans lesquels des broches de raccordement (6) enveloppées individuellement ou en commun par une gaine ressortent à l'extérieur à partir d'appendices saillants (8a) de la bride du corps de bobine, une étanchéité étant établie entre les appendices saillants de la bride et de la partie de fond (30) et éventuellement en supplément entre les broches de raccordement (6) et les appendices saillants (8a) des brides.

8. Relais suivant l'une des revendications 1 à 7, caractérisé par le fait que la section de fond (35;45) décalée en hauteur s'étend au moins sur une bride jusqu'au bord du capot (1) et que, dans cette section de fond (35;45) sont ménagés des passages (34) pour des broches de raccordement (7), qui sont enveloppées par des appendices saillants en forme de colonnes (9a) du corps de bobine, qui s'étendent jusqu'au plan inférieur de terminaison (3), I'étanchéité étant réalisée avec une résine de coulée entre la partie de fond (30;40) et les appendices saillants (9a) du corps de bobine dans le plan de jonction (4) décalé en hauteur.

9. Relais suivant la revendication 1 ou 2, caractérisé par le fait que la partie de fond (40) s'étend essentiellement seulement dans la zone de la section de fond (45) décalée en hauteur et que des appendices saillants (18) de la bride et/ou des appendices saillants en forme de colonnes (9a) du corps de bobine, dans lesquels sont enchâssées des broches de raccordement (6;7), s'étendent entre le bord du capot et la pièce de fond (40) et/ou dans des passages (34) de la pièce de fond, jusqu'au plan inférieur de terminaison.

10. Relais suivant l'une des revendications 1 à 9, caractérisé par le fait que le capot (5) comporte, dans la zone située latéralement à côté de l'enroulement de bobine, des rétrécissements supplémentaires (52).
